# EUROPÄISCHE PATENTSCHRIFT

(11) **EP 0 811 367 B1**
(45) Veröffentlichungstag und Bekanntmachung des Hinweises auf die Patenterteilung: **23.05.2001**
(21) Anmeldenummer: 97104498.7
(22) Anmeldetag: 17.03.1997
(51) Int. Cl.: A61J 1/00, B65D 23/02, C03C 17/22, C03C 17/245

(54) **Glasbehälter insbesondere zur Aufbewahrung pharmazeutischer oder diagnostischer Lösungen**
Glass container particularly for storing pharmaceutical or diagnostic solutions
Récipient en verre particulièrement pour stocker des solutions pharmaceutiques ou diagnostiques

(30) Priorität: 05.06.1996 DE 19622550
(43) Veröffentlichungstag der Anmeldung: 10.12.1997
(73) Patentinhaber: Schott Glas, 55122 Mainz (DE); CARL-ZEISS-STIFTUNG trading as Schott Glas, 55122 Mainz (DE)
(72) Erfinder: Spallek, Michael, Dr., 55218 Ingelheim (DE); Walther, Marten Dr., 55270 Engelstadt (DE); Lohmeyer, Manfred, 55299 Nackenheim (DE); Heming, Martin, Dr., 55442 Stromberg (DE)

(56) Entgegenhaltungen:
- EP-A- 0 446 596
- EP-A- 0 665 304
- DE-A- 19 502 103
- FR-A- 2 697 014
- US-A- 3 182 839
- US-A- 3 833 406
- PATENT ABSTRACTS OF JAPAN vol. 014, no. 446 (C-0763), 25.September 1990 & JP 02 175630 A (MATSUMOTO SEIYAKU KOGYO KK ET AL), 6.Juli 1990,
- BORCHERT S.J. ET AL: "Accelerated Extractable Studies of Borosilicate Glass Containers" JOURNAL OF PARENTERAL SCIENCE AND TECHNOLOGY, Bd. 43, Nr. 2, 1.März 1989, Seiten 67-79, XP000197458

## Beschreibung

Glasbehälter zur Aufbewahrung pharmazeutischer oder diagnostischer Lösungen sind dazu bestimmt, in direkten Kontakt mit diesen Lösungen zu kommen. Verschiedene Arten von Glasbehältern kommen zur Anwendung, beispielsweise Ampullen, Fläschchen, Spritzenkörper für Fertigspritzen, Zylinderampullen und Behältnisse zur Aufnahme von Blut und Blutproben.

Es ist bekannt, daß sich bei allen Glasbehältnissen und selbst bei Glasbehältnissen aus Borosilikatglas, die gemäß den Pharmakopöen (z. B, Deutsches Arzneibuch DAB 10) in die höchste Beständigkeitsklasse eingestuft werden, Wechselwirkungen der Lösungen mit der Glasoberfläche nachweisen lassen. Die Wechselwirkungen bei Glasbehältnissen aus Kalk-Natron-Glas sind allerdings noch bedeutend größer.

Die Wechselwirkung beruht in erster Linie auf der Auslaugung von alkalischen Stoffen aus der Glasoberfläche durch die wäßrige Lösung. Diese Auslaugung kann während der Lagerung der Lösung zu einer unerwünschten Erhöhung des pH-Wertes, z. B. bei Wasser für Injektionszwecke, um mehrere pH-Einheiten führen (z. B. Borchert et al., J. of Parenteral Science & Technology, Vol. 43, No. 2, March/April 1989).

Auch kann bei manchen Medikamenten ein Teil der Wirksubstanz durch aus dem Glas gelöste Ionen inaktiviert werden, was besonders bei niedrig dosierten Medikamenten stört.

Die Aufgabe der Erfindung besteht daher darin, einen Glasbehälter zur Aufbewahrung pharmazeutischer oder diagnostischer Lösungen zu finden, der sich gegenüber diesen Lösungen in hohem Maße inert verhält, d. h. bei dem die Menge an durch die Lösungen aus dem Glas ausgelaugten Ionen minimiert ist.

Diese Aufgabe wird durch den im Patentanspruch 1 beschriebenen Glasbehälter gelöst.

Der Glasbehälter ist auf seiner Innenseite, d. h. auf seiner mit den Lösungen in Kontakt stehenden Oberfläche mit einer Schicht aus Oxiden und/oder Nitriden der Elemente Si, Ti, Ta, Al oder Mischungen davon überzogen, wobei diese Schicht mittels eines Plasma-CVD-Verfahrens (PCVD-Verfahren) erzeugt worden ist. Insbesondere ist die Schicht durch das Plasma-Impuls-CVD-Verfahren (PICVD-Verfahren) hergestellt worden.

Bei diesen Verfahren findet eine Schicht-Abscheidung aus der Gasphase (Chemical Vapour Deposition = CVD) statt, wobei die zur Spaltung der Precursor-Gase erforderliche Energie durch ein elektrisches Hochfrequenzplasma in das System eingebracht wird. Diese Verfahren sind an sich wohlbekannt.

Überraschend hat sich gezeigt, daß ein Glasbehälter mit nach dem PCVD- bzw. PICVD-Verfahren hergestellten Schichten eine ganz überragende Widerstandsfähigkeit gegenüber der Auslaugung besitzt und sich damit gegenüber denen in ihm gelagerten Lösungen in höchstem Maße inert verhält.

Besonders geeignet sind oxidische Schichten, insbesondere solche aus SiO₂ und TiO₂, wobei SiO₂ bevorzugt wird. Die Dicke der Schichten soll etwa 10 bis 1000 nm betragen, eine Dicke zwischen 20 und 1000 nm, insbesondere 20 bis 500 nm ist bevorzugt. Es können auch mehrere Schichten unterschiedlicher Zusammensetzung als Schichtenpaket abgeschieden werden, wobei das Schichtenpaket die o.a. Schichtdicke besitzen soll.

Die Zusammensetzung des Glases, aus dem der Behälter besteht, ist nicht kritisch. Im allgemeinen wird man die für pharmazeutische Anwendungen üblichen farblosen und gefärbten Gläser einsetzen. Bevorzugt werden jedoch Gläser, die bereits an sich einer niedrigen hydrolytischen Klasse angehören, verwendet, also insbesondere die sog. Neutralgläser (Borosilikatgläser) (DAB 10).

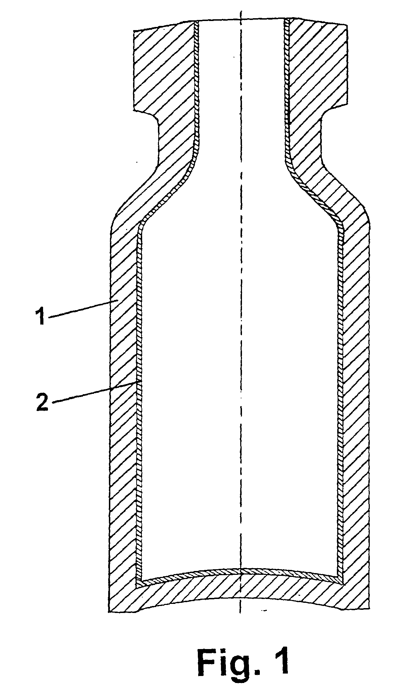

Die Abbildung zeigt in Figur 1 beispielhaft ein 10 ml Injektionsfläschchen aus Glas. Das Fläschchen besteht aus Glas 1, dessen Innenseite mit einer SiO₂ -Schicht 2 versehen ist. Die Dicke der SiO₂ -Schicht ist nicht maßstabsgetreu dargestellt.

Die hervorragenden Eigenschaften des erfindungsgemäßen Behälters werden an folgendem Beispiel gezeigt:

Ein Glasbehälter aus Borosilikatglas der Zusammensetzung 75 % SiO₂, 11 % B₂O₃, 5 % Al₂O₃, 7 % Na₂O, 2 % CaO + BaO in der Form eines Injektionsfläschchens für 10 ml Inhalt, der auf seiner Innenseite eine nach dem PICVD-Verfahren aufgebrachte 150 nm dicke SiO₂-Schicht besitzt, wird mit 2 ml 0,4 mol HCI gefüllt und anschließend 1 Stunde bei 121 °C autoklaviert. Anschließend wird die Menge an freigesetzten Natrium-, Calcium-, Aluminium-, Bor- und Silicium-Kationen in µg/l bestimmt. Zum Vergleich wurde der Versuch mit einem identischen Behälter wiederholt, der jedoch nicht mit einer Innenbeschichtung versehen war. Die Ergebnisse sind in der Tabelle zusammengefaßt.

| | **Vergleich** | |
|---|---|---|
| **Kationen Freisetzung** | **Borosilikatglas ohne Schicht (µg/l)** | **Borosilicatglas mit 150 nm SiO**_{**2**}**-Schicht (µg/l)** |
| Natrium (Na) | 3,5 | < Nachweisgrenze von 0,01 |
| Kalzium (Ca) | 1,1 | < Nachweisgrenze von 0,05 |
| Bor (B) | 3,5 | < Nachweisgrenze von 0,10 |
| Aluminium (Al) | 2,3 | < Nachweisgrenze von 0,05 |
| Silizium (Si) | 5.0 | < Nachweisgrenze von 0,30 |

Die angegebenen Werte sind Mittelwerte aus jeweils 32 geprüften Glasbehältern. Bei dem erfindungsgemäßen Glasbehälter bleibt die Menge der ausgelaugten Kationen stets unterhalb der Nachweisgrenze. Besonders überraschend ist es, daß trotz einer SiO₂ -Konzentration von 100 % in der Schicht die ausgelaugte Menge an Silonen deutlich niedriger ist, als bei der Vergleichsprobe, obwohl dort die SiO₂ - Konzentration in der mit der Lösung in Kontakt stehenden Wand nur 75 Gew.-% beträgt.

## Patentansprüche

1. Glasbehälter insbesondere zur Aufbewahrung pharmazeutischer oder diagnostischer Lösungen,
**dadurch gekennzeichnet,**
daß seine mit den Lösungen in Kontakt stehende Oberfläche mit einer mittels eines Plasma-CVD-Verfahrens aufgebrachten Schicht aus Oxiden und/oder Nitriden der Elemente Si, Ti, Ta, Al oder Mischungen davon überzogen ist.

2. Glasbehälter nach Anspruch 1,
**dadurch gekennzeichnet,**
daß die Schicht 20 bis 1000 nm dick ist.

3. Glasbehälter nach Anspruch 1 oder 2,
**dadurch gekennzeichnet,**
daß die Schicht aus SiO₂ besteht.

4. Glasbehälter nach wenigstens einem der Ansprüche 1 bis 3,
**dadurch gekennzeichnet,**
daß die Schicht mittels des Plasma-Impuls-CVD-Verfahrens aufgebracht ist.

## Claims

1. Glass container, in particular for storing pharmaceutical or diagnostic solutions, characterized in that its solution-contacting surface is coated with a plasma-CVD deposited layer consisting of oxides and/or nitrides of the elements Si, Ti, Ta, Al or mixtures thereof.

2. Glass container according to Claim 1, characterized in that the layer is 20-1000 nm thick.

3. Glass container according to Claim 1 or 2, characterized in that the layer consists of SiO₂.

4. Glass container according to at least one of Claims 1 to 3, characterized in that the layer has been deposited by the plasma impulse CVD method.

## Revendications

1. Récipient en verre, en particulier pour la conservation de solutions pharmaceutiques ou diagnostiques, caractérisé en ce que la surface de ce dernier en contact avec les solutions est recouverte d'une couche appliquée à l'aide d'un procédé de dépôt en phase gazeuse à plasma, en oxydes et/ou en nitrures des éléments Si, Ti, Ta, Al ou de mélanges de ces derniers.

2. Récipient en verre selon la revendication 1, caractérisé en ce que la couche a une épaisseur de 20 à 1000 nm.

3. Récipient en verre selon la revendication 1 ou 2, caractérisé en ce que la couche se compose de SiO₂.

4. Récipient en verre selon au moins l'une des revendications 1 à 3, caractérisé en ce que la couche est appliquée à l'aide du procédé de dépôt en phase gazeuse par impulsion à plasma.
